# EUROPÄISCHE PATENTANMELDUNG

(11) **EP 0 534 133 A1**
(43) Veröffentlichungstag der Anmeldung: **31.03.1993**
(21) Anmeldenummer: 92114206.3
(22) Anmeldetag: 20.08.1992
(51) Int. Cl.: H01L 23/10, H01L 21/50, H01L 23/057

(54) **Vorrichtung zur isolierten Herausführung von Leiterbahnen aus einem Abschirmgehäuse**

(30) Priorität: 21.09.1991 DE 4131534
(71) Anmelder: Alcatel SEL Aktiengesellschaft, D-70435 Stuttgart (DE); ALCATEL N.V., NL-1077 XX Amsterdam (NL)
(72) Erfinder: Baumgärtner, Armin, Dr., W-7140 Ludwigsburg (DE); Heck, Wolfgang, W-7016 Gerlingen (DE); Springer, Johann, Dr., W-7357 Aichwald (DE); Adam, Klaus, W-7320 Göppingen (DE); Hägele, Kurt, W-7014 Kornwestheim (DE)
(74) Vertreter: Pohl, Herbert, Dipl.-Ing

(57) **Zusammenfassung**

In der Elektronik sind häufig eine große Anzahl von IC's dicht nebeneinander auf einer gedruckten Schaltung angeordnet. Das ist in der Weise verwirklicht, daß der oder die IC's auf einem Zwischenträger (1) beispielsweise einer Keramikplatte, befestigt und ihre Anschlüsse mit Leiterbahnen auf dem Zwischenträger kontaktiert sind. Wenn die IC's (6) in einem Abschirmgehäuse (4) angeordnet sind, ergibt sich die Notwendigkeit, die Leiterbahnen (5) isoliert durch die Wand (8) des Abschirmgehäuses hindurchzuführen. Als einfach zu verwirklichende Lösung dafür ist vorgeschlagen, die Leiterbahnen auf der Oberfläche des Zwischenträgers anzuordnen und zwischen dem Fußpunkt der Abschirmgehäusewand und den Leiterbahnen eine Isolationsschicht (10) und eine lötbare Metallschicht (11) vorzusehen.

## Beschreibung

Die Erfindung betrifft eine Vorrichtung zur isolierten Herausführung von Leiterbahnen aus einem Abschirmgehäuse, in dem auf einem Zwischenträger eine Dünnschicht-Mehrebenenschaltung mit wenigstens einer darauf befestigten integrierten Schaltung angeordnet ist.

Eine solche Vorrichtung ist bekannt (Druckschrift: "Thin Film Polyimide Multichip Modules" der Fa. Advanced Packaging Systems S. 26). Bei der bekannten Vorrichtung ist auf einem Zwischenträger, beispielsweise einer Keramikplatte, eine Dünnschicht-Mehrebenenschaltung angeordnet, auf welcher wenigstens eine integrierte Schaltung befestigt ist. Die elektrischen Anschlüsse der integrierten Schaltung sind über Mikrodrähte mit Dünnschichtleitern auf der Mehrebenenschaltung verbunden. Die Dünnschicht-Mehrebenenschaltung ist in einem Abschirmgehäuse angeordnet, dessen Wand auf dem Zwischenträger befestigt ist. Um elektrisch leitende Verbindungen zwischen der Dünnschicht-Mehrebenenschaltung und den am Rand des Zwischenträgers gelegenen Anschlußkontakten zu schaffen, sind unterhalb der Wand des Abschirmgehäuses verlaufende, im Zwischenträger eingebettete Leitungen vorgesehen.

Diese bekannte Art der Herausführung der leitenden Verbindungen aus dem Inneren des Abschirmgehäuses zum Rand des Zwischenträgers macht erhebliche fertigungstechnische Schwierigkeiten, weil diese in dem Zwischenträger eingebetteten Leiterbahnen nur dadurch erzeugt werden können, daß dieser als Dickschicht-Mehrebenenschaltung mit Keramikisolationsschichten hergestellt wird. Die Durchführbarkeit dieses Herstellungsverfahrens wird durch die Breite der Leiterbahnen begrenzt.

Das der Erfindung zugrundeliegende technische Problem besteht darin, die bekannte Vorrichtung in der Weise zu verbessern, daß die Herausführung der leitenden Verbindungen einfacher zu bewerkstelligen ist.

Dieses technische Problem ist erfindungsgemäß dadurch gelöst, daß die Leiterbahnen auf der Oberfläche des Zwischenträgers angeordnet sind und zwischen dem Fußpunkt der Abschirmgehäusewand und den Leiterbahnen eine Isolationsschicht und eine lötbare Metallschicht angeordnet sind.

Diese Lösung hat einerseits den Vorteil, daß die die Herausführungen bildenden Leiterbahnen nicht in den Zwischenträger eingebettet werden müssen. Andererseits ist es nicht notwendig, die Isolationsschicht und die lötbare Metallschicht in eigenen Verfahrensschritten herzustellen. Sie können vielmehr im gleichen Arbeitsgang bei der Herstellung der entsprechenden leitenden Schichten und Isolationsschichten der Dünnschicht-Mehrebenenschaltung mit hergestellt werden.

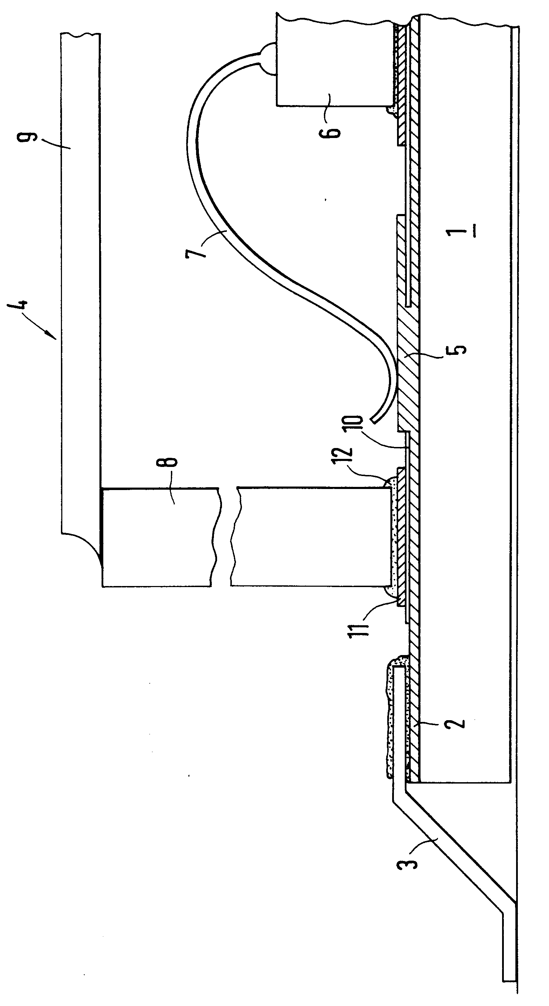

Die Erfindung ist nachstehend anhand der Figur erläutert, welche einen Längsschnitt durch ein Ausführungsbeispiel der erfindungsgemäßen Vorrichtung zeigt. In der Figur ist der Zwischenträger 1 zu erkennen, welcher auf einer - nicht gezeigten - gedruckten Schaltung befestigt und dessen Kontaktflächen 2 über Anschlußbeine 3 mit Leiterbahnen der gedruckten Schaltung elektrisch leitend verbunden sind.

Auf dem Zwischenträger 1 ist innerhalb des Abschirmgehäuses 4 die Dünnschicht-Mehrebenenschaltung 5 angeordnet, auf welcher die integrierte Schaltung 6 befestigt ist. Die elektrisch leitenden Verbindungen zwischen der integrierten Schaltung 6 und der Dünnschicht-Mehrebenenschaltung 5 sind durch die Mikrodrähte 7 verwirklicht.

Das Abschirmgehäuse 4 besteht aus der als Rahmen geformten Wand 8 und dem Deckel 9.

Zwischen den Kontaktflächen 2 und dem unteren Ende der Wand 8 sind die Isolationsschicht 10 und die lötbare Metallschicht 11 angeordnet. Die Wand 8 ist mittels eines Lötmetalls 12 mit der Metallschicht 11 verlötet.

Die Dünnschicht-Mehrebenenschaltung besteht beispielsweise aus der abwechselnden Anordnung von Leiterbahnen aus Aluminiumschichten und Isolationsschichten aus Polyimid. Die auf der obersten Polyimidschicht aufgebrachte lötbare Schicht besteht beispielsweise aus aufgedampftem Chrom + Nickel + Gold. Auf diese Schicht wird mittels einer Photomaske auf bestimmte Flächen, beispielsweise an denen die Bauelemente oder der Rahmen 8 angelötet werden sollen, ein Lötwerkstoff (z.B. PbSn) galvanisch aufgebracht.

## Patentansprüche

1. Vorrichtung zur isolierten Herausführung von Leiterbahnen aus einem Abschirmgehäuse, in dem auf einem Zwischenträger eine Dünnschicht-Mehrebenenschaltung mit wenigstens einer darauf befestigten integrierten Schaltung angeordnet ist,
**dadurch gekennzeichnet,**
daß die Leiterbahnen auf der Oberfläche des Zwischenträgers angeordnet sind und zwischen dem Fußpunkt der Abschirmgehäusewand und den Leiterbahnen eine Isolationsschicht und eine lötbare Metallschicht angeordnet ist.
